(19) **Europäisches Patentamt / European Patent Office / Office européen des brevets**

(11) **EP 3 648 020 B1**

(12) **FASCICULE DE BREVET EUROPEEN**

(45) Date de publication et mention de la délivrance du brevet:
**15.03.2023 Bulletin 2023/11**

(21) Numéro de dépôt: **19202488.3**

(22) Date de dépôt: **10.10.2019**

(51) Classification Internationale des Brevets (IPC):
**G06Q 10/04** *(2012.01)*  **G06Q 10/00** *(2006.01)*
**G06Q 50/06** *(2012.01)*  **H02J 3/00** *(2006.01)*
**H02J 3/12** *(2006.01)*  **H02J 3/32** *(2006.01)*
**H02J 3/38** *(2006.01)*

(52) Classification Coopérative des Brevets (CPC):
**G06Q 50/06; G06Q 10/04; G06Q 10/20; H02J 3/003; H02J 3/12; H02J 3/32; H02J 3/381;** H02J 2203/20; H02J 2300/20; Y02A 90/10; Y02B 10/10; Y02B 90/20; Y02E 10/56; Y02E 60/00; Y04S 10/50; (Cont.)

(54) **SÉCURISATION D'UNE INTERVENTION SUR UNE BRANCHE BASSE TENSION D'UN RÉSEAU DE DISTRIBUTION ÉLECTRIQUE**

ABSICHERUNG EINES EINGRIFFS IN EINEM NIEDRIGSPANNUNGSZWEIG EINES STROMVERSORGUNGSNETZES

MAKING SAFE A MAINTENANCE OPERATION IN A LOW VOLTAGE BRANCH OF A POWER GRID

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **31.10.2018 FR 1871345**

(43) Date de publication de la demande:
**06.05.2020 Bulletin 2020/19**

(73) Titulaire: **Electricité de France**
**75008 Paris (FR)**

(72) Inventeurs:
• **CHARPENTIER, Philippe**
**78830 BULLION (FR)**
• **MEVEL, Camille**
**29200 BREST (FR)**

(74) Mandataire: **Plasseraud IP**
**66, rue de la Chaussée d'Antin**
**75440 Paris Cedex 09 (FR)**

(56) Documents cités:
• **Séquélec: "Prévention du risque électrique lors d'opérations sur les ouvrages en basse tension du < Réseau Public de Distribution > (RPD)", , 1 octobre 2015 (2015-10-01), XP055606639, Extrait de l'Internet:**
URL:https://www.enedis.fr/sites/default/files/Guide_SeQuelec_Ndeg14_Prevention_du_risque_electrique_151027.pdf [extrait le 2019-07-17]

(52) Classification Coopérative des Brevets (CPC):
(Cont.)
Y04S 20/12; Y04S 40/20

**Description**

La présente invention concerne la sécurisation de personnes devant effectuer une intervention sur une branche basse tension d'un réseau de distribution d'électricité.

Lors d'une telle intervention (prévue ou suite à un incident), le courant électrique doit être coupé pour que du personnel intervenant puisse travailler en toute sécurité. Cependant, avec le développement des moyens autonomes de production d'énergie électrique renouvelable (panneaux photovoltaïques, éoliennes, ou autres) auprès de particuliers, il peut advenir que le réseau puisse être encore alimenté par ces moyens autonomes alors que le poste d'alimentation basse tension a été arrêté par le gestionnaire du réseau de distribution. En effet, lorsque les moyens autonomes sont déployés directement par un particulier (et non l'entreprise qui gère le réseau) et que le particulier ne déclare pas au gestionnaire du réseau la présence de ces moyens autonomes, il se peut sur place qu'un onduleur par exemple ne soit pas alimenté par le réseau électrique mais par un panneau photovoltaïque ou une éolienne directement. En cas de coupure sur le réseau électrique, le rôle de l'onduleur est normalement de couper la production du panneau à condition que l'onduleur soit bien relié au réseau principal basse tension. Dans le cas contraire ou en absence d'onduleur, le ou les panneaux continuent à produire et alimentent ainsi le réseau électrique basse tension du voisinage.

Par conséquent, les intervenants sur le réseau sont en danger s'ils ne vérifient pas la tension du réseau. Si une tension non nulle est détectée sur le réseau bien que le poste d'alimentation et les installations photovoltaïques déclarées soient arrêtées, les agents de maintenance doivent rechercher dans le voisinage en faisant du porte à porte, l'ensemble des installations d'autoproduction non déclarées afin de les désactiver. Hormis la mise en danger des agents, on comprend bien que cette démarche est longue et fastidieuse, en laissant sans électricité les usagers reliés au poste basse tension.

Le document D1 : « Guide SeQuelec » (XP055606639) (17/7/2019) mentionne une mise hors tension dans le cadre d'une intervention sur un réseau publique de distribution, compte tenu de la présence possible de sources de production autonomes sur le site d'intervention. Néanmoins, il n'évoque nullement la prise en compte de relevés historiques de compteurs électriques et de conditions météorologiques pour identifier un risque de présence de tels moyens autonomes sur site.

La présente invention vient améliorer cette situation.

Elle propose à cet effet un procédé de sécurisation de personnes devant effectuer une intervention sur une branche basse tension d'un réseau de distribution d'électricité, dans lequel la branche basse tension est typiquement reliée à un poste alimentant une pluralité de logements dans un secteur géographique. Les logements sont équipés de compteurs configurés pour mesurer et communiquer des consommations par pas de temps réguliers (journalier, ou semi-horaires typiquement).

Comme une partie au moins des logements est susceptible de comporter des moyens autonomes de production d'électricité par usage d'énergie renouvelable, une mise en service desdits moyens autonomes peut générer une tension électrique dans la branche basse tension, malgré une coupure du poste d'alimentation pendant l'intervention, et mettre ainsi en danger les personnes pendant leur intervention.

Le procédé, mis en oeuvre par un serveur communiquant avec les compteurs précités, comporte alors les étapes :

- obtenir des premières données, de relevés de consommations issus de chaque compteur par pas de temps réguliers,
- obtenir des deuxièmes données, météorologiques dans le secteur géographique, pour identifier au moins des conditions propices à la production d'énergie par lesdits moyens autonomes,
- pour chaque compteur, appliquer un modèle de détection, en fonction au moins des premières et deuxièmes données, d'une coïncidence entre des périodes de baisse de consommation mesurée par le compteur et des conditions météorologiques propices à la production électrique par lesdits moyens autonomes pendant lesdites périodes, et déduire de l'application du modèle une information de présence de moyens autonomes dans le logement équipé de ce compteur,

- stocker dans une base de données l'information de présence de moyens autonomes en correspondance d'un identifiant propre au logement, pour chaque logement,
- et, avant l'intervention, identifier dans la base de données les logements susceptibles de comporter des moyens autonomes.

Ci-dessus, on entend par le terme « logement » aussi bien une habitation, un bureau, ou une usine.

On entend par « énergie renouvelable » aussi bien une énergie solaire et/ou une énergie éolienne, qui dépendent directement des conditions météorologiques précitées (voire une énergie hydraulique de cours d'eau dont le débit dépend de la pluviométrie, et donc là encore, des conditions météorologiques).

Par la mise en oeuvre de l'invention, on identifie non seulement les logements équipés de moyens de production autonomes (donc « autoproducteurs »), mais en plus ceux qui consomment leur propre énergie autoproduite (logements dits « autoconsommateurs » ci-après) et qui aliment alors le réseau BT en risquant de mettre en danger les intervenants.

Dans une forme de réalisation, le serveur peut obtenir en outre une mesure instantanée de la tension sur la branche basse tension, typiquement avant l'intervention. Ainsi, l'intervention peut être conditionnée par l'obtention au serveur d'une mesure de tension nulle sur la branche basse tension.

Dans une telle réalisation, comme chaque compteur peut être configuré pour être coupé à distance, typiquement par une commande du serveur, l'information de présence précitée peut se présenter sous la forme d'un score de probabilité de présence de moyens autonomes dans le logement équipé d'un tel compteur, et le procédé peut comporter en outre les étapes :

- établir une liste des scores de probabilité de présence de moyens autonomes, en correspondance d'identifiants de compteurs respectifs,
- en cas d'obtention d'une tension mesurée comme non nulle sur la branche basse tension, utiliser l'identifiant de compteur ayant le score maximum dans ladite liste pour couper à distance ce compteur, puis supprimer ce compteur de la liste et réitérer cette étape jusqu'à obtention d'une mesure de tension nulle sur la branche.

Selon un premier mode de réalisation, le modèle de détection est obtenu par une technique dite de « boosting d'arbres » comprenant :

- un renseignement de variables dans un échantillon d'apprentissage composé de logements dont les consommations sont analysées,
- une définition de variables explicatives de la corrélation, tirées des variables renseignées, et
- une application de la méthode de boosting d'arbres aux variables explicatives pour déterminer un modèle de calcul d'un score de probabilité de présence de moyens autonomes dans un logement équipé d'un compteur mesurant et communiquant des consommations dans le logement par pas de temps réguliers, ledit score correspondant à ladite information de présence stockée dans la base de données.

Ainsi, on comprendra que ce modèle de calcul de score, dès lors que ce score quantifie la probabilité de présence de moyens autonomes, peut correspondre finalement au modèle de détection précité.

Dans cette réalisation, une validation croisée peut être appliquée en outre pour consolider la détermination du modèle de calcul.

Selon un deuxième mode de réalisation, le modèle de détection est obtenu par la mise en oeuvre d'un réseau de neurones convolutifs, cette mise en oeuvre comprenant :

- un renseignement de variables dans un échantillon d'apprentissage composé de logements dont les consommations sont analysées,
- un apprentissage par le réseau de neurones de l'échantillon, et
- la détermination par le réseau de neurones d'un modèle de calcul d'un score de probabilité de présence de moyens autonomes dans un logement équipé d'un compteur mesurant et communiquant des consommations dans le logement par pas de temps réguliers, ce score correspondant alors à l'information de présence précitée, stockée dans la base de données.

Dans le premier ou dans le deuxième mode de réalisation, on peut prendre des variables communes à renseigner dans l'échantillon d'apprentissage, ces variables pouvant être, pour chaque logement, parmi :

- La variable à prédire en tant que telle, indiquant donc si le logement est équipé de moyen de production autonome ou non ;
- La consommation du logement par pas régulier ;
- Des conditions météorologiques dans le secteur de ce logement, incluant une température instantanée dans ce secteur.

Par exemple si le moyen de production autonome dont on cherche à détecter la présence est un panneau photovoltaïque, alors les conditions météorologiques peuvent inclure au moins un degré d'ensoleillement (ou « irradiance », ou encore « rayonnement », ci-après) à un instant donné.

Ainsi, dans le cas où en outre chaque compteur peut mesurer et communiquer des consommations à un pas horaire ou infra-horaire, les variables explicatives peuvent comporter au moins une variable parmi:

- Un ratio moyen par compteur entre une consommation entre 10 heures et 16 heures d'une journée et une consommation totale sur la même journée complète,

- Une pente de ligne de régression de la consommation entre 12 heures et 14 heures par degré ensoleillement,
- Un ratio entre une consommation moyenne sur l'ensemble des compteurs entre 10 heures et 16 heures pour les X jours à plus forts degrés d'ensoleillement et celle entre 10 heures et 16 heures pour les X jours à plus faibles degrés d'ensoleillement,
- Un ratio moyen par compteur entre la consommation entre 10 et 16 heures et les degrés en température du même jour entre 10 et 16 heures,
- Un ratio moyen de consommation par degré de température entre 10 et 16 heures pour les X jours à plus forts degrés d'ensoleillement et une consommation par degré de température entre 10 et 16 heures pour les X jours à plus faibles degrés d'ensoleillement.

Dans le cas où chaque compteur peut mesurer et communiquer des consommations plutôt à un pas journalier, les variables explicatives peuvent comporter au moins une variable parmi :

- Un ratio de consommation sur une journée par degré d'ensoleillement sur la même journée ;
- Un ratio de consommation sur une journée par degré d'ensoleillement moyen entre 10 et 16 heures de cette journée ;
- Un ratio de consommation sur une journée par degré d'ensoleillement moyen entre 12 et 14 heures de cette journée ;
- Un ratio de consommation sur une journée par degré d'ensoleillement maximum entre 10 et 16 heures de cette journée ;
- Un ratio de consommation sur une journée par degré d'ensoleillement maximum entre 12 et 14 heures de cette journée;
- Un ratio entre la consommation moyenne par jour pour les X jours à plus forts degrés d'ensoleillement et la consommation moyenne pour les X jours à plus faibles degrés d'ensoleillement ;
- Un ratio moyen de consommation par jour par degrés de température ;
- Un ratio moyen entre la consommation par jour par degré de température pour les X jours à plus forts degrés d'ensoleillement et une consommation par jour par degré de température pour les X jours à plus faibles degrés d'ensoleillement.

La présente invention vise en outre un programme informatique comportant des instructions pour la mise en oeuvre du procédé ci-avant, lorsque ces instructions sont exécutées par un processeur d'un module de traitement.

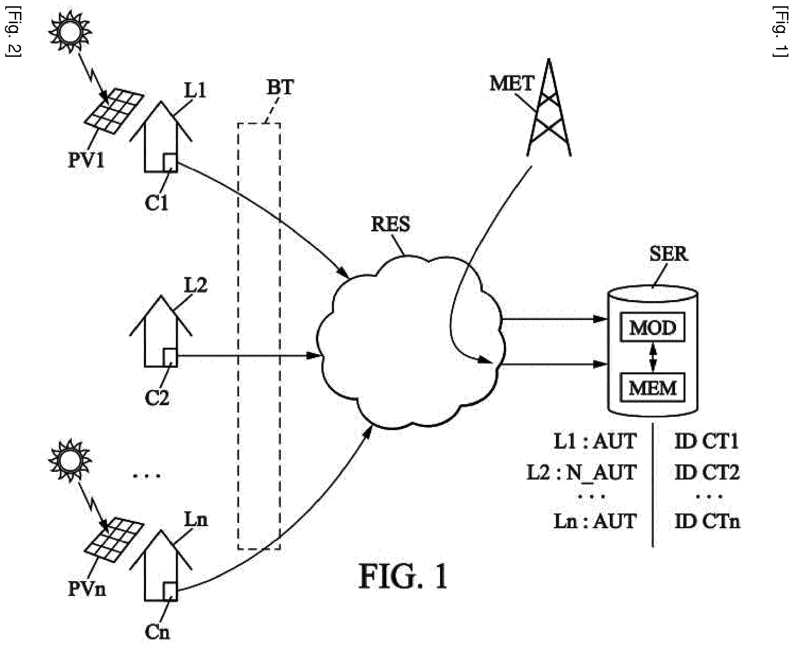

Elle vise aussi un serveur, pour la mise en oeuvre du procédé ci-avant, et comportant une mémoire (référence MEM de la figure 1) pour stocker la base de données et un module de traitement (référence MOD de la figure 1) configuré pour appliquer le modèle de détection de moyen de production autonome dans un logement, à partir au moins des premières données de consommation issues du compteur de ce logement, et des deuxièmes données de conditions météorologiques dans le secteur de ce logement.

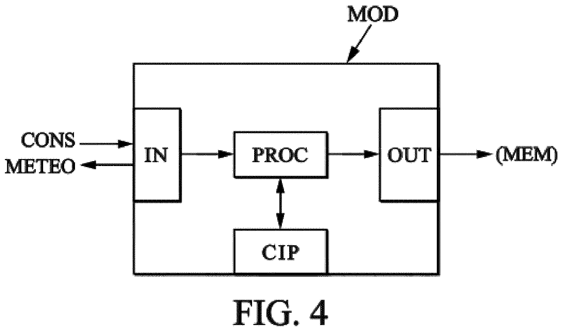

Ce module de traitement (MOD, détaillé sur la figure 4) peut se présenter sous la forme d'un circuit électronique avec une entrée IN (une interface de communication typiquement) pour recevoir les premières données (CONS) et les deuxièmes données (METEO), une mémoire CIP pour stocker les codes d'instructions du programme informatique au sens de l'invention, un processeur PROC (comme évoqué ci-dessus) pour coopérer avec cette mémoire CIP, lire les codes d'instructions stockées, et exécuter le programme informatique afin d'appliquer le modèle de détection et, de là, fournir pour un logement l'information de présence de moyens autonomes (via la sortie OUT du module MOD) afin d'alimenter ainsi la base de données stockée dans la mémoire MEM du serveur.

Le module MOD et la base de données MEM peuvent être regroupés auprès d'un même serveur SER (comme illustré sur la figure 1) ou auprès de plusieurs entités informatiques distinctes communiquant via un réseau.

A ce titre, la présente invention vise aussi un module de traitement d'un serveur au sens de l'invention, tel que présenté ci-avant à titre d'exemple.

**Brève description des dessins**

D'autres avantages et caractéristiques de l'invention apparaitront à la lecture de la description détaillée ci-après d'exemples de réalisation et à l'examen des dessins annexés sur lesquels :

**Fig. 1**
[Fig. 1] illustre un exemple de système pour la mise en oeuvre de l'invention,

**Fig. 2**

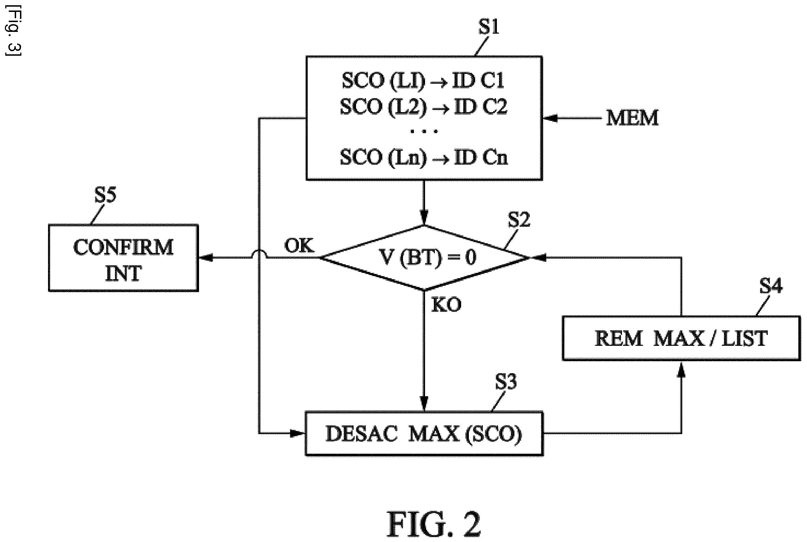

[Fig. 2] illustre un exemple de procédé au sens de l'invention selon un mode de réalisation particulier;

**Fig. 3**

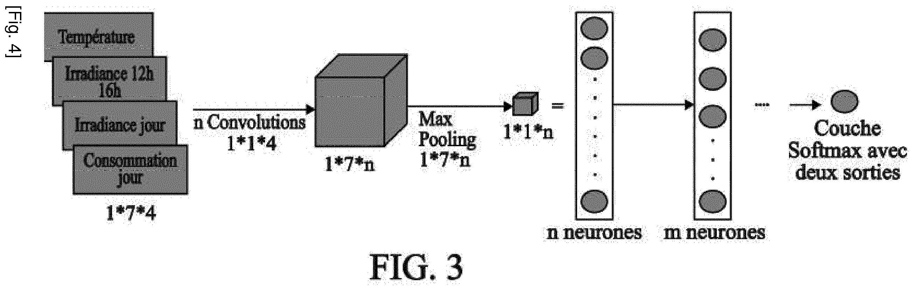

[Fig. 3] illustre une approche de construction d'un modèle de prédiction par apprentissage profond, l'utilisation du modèle lui-même donnant la liste des logements où la présence d'un moyen de production autonome est probable;

**Fig. 4**
[Fig. 4] illustre schématiquement un module de traitement d'un serveur au sens de l'invention.

## Description des modes de réalisation

Dans la description présentée ici, on cherche à détecter une présence locale de moyens autonomes de production d'énergie (comme un ou plusieurs modules photovoltaïques et/ou une ou plusieurs éoliennes).

On identifie ainsi une autoproduction d'énergie, et surtout l'existence de courant ou de tension malgré une coupure d'alimentation dans un secteur du réseau basse tension.

Les moyens autonomes de production d'énergie ne sont pas toujours déclarés aux équipes de maintenance du réseau basse tension, ce qui peut mettre en danger ces équipes comme expliqué précédemment.

La solution proposée par l'invention est de détecter les autoproducteurs non déclarés à l'aide :

- des données de consommation électrique sur une période donnée (par exemple une courbe de charge avec un pas correspondant à une journée ou encore 30 minutes), et de là, identifier des périodes de sous-consommation par rapport à une consommation moyenne, en interrogeant les compteurs communicants d'une branche basse tension du réseau de distribution, sur laquelle est proposée l'intervention,
- Et de données météorologiques de la station météorologique la plus proche pour identifier sur les périodes de sous-consommation si les conditions météorologiques étaient propices à une autoproduction (par exemple une irradiance élevée, ou un fort vent), auquel cas il est identifié des moyens de production autonome d'électricité (respectivement un ou plusieurs panneaux photovoltaïques, ou une ou plusieurs éoliennes) dans les locaux dans lesquels sont installés les compteurs communicants précités.

En couplant les deux sources de données (données de courbes de charge et données météorologiques), il est alors possible d'observer que certains utilisateurs qui détiendraient par exemple des panneaux photovoltaïques consomment moins que la normale quand l'irradiance est élevée et normalement quand l'irradiance est faible.

A partir de ce constat, il est proposé, plus loin dans la présente description, une identification de variables pertinentes illustrant ce phénomène, puis une modélisation permettant de calculer un score de probabilité définissant si le client est auto-consommateur ou non (s'il consomme la production électrique issue de ses moyens autonomes de production).

En cas d'intervention, si les agents risquent d'être confrontés à une tension non nulle bien que le poste de la branche basse tension BT soit coupé, il suffit donc de relever l'historique des compteurs et d'appliquer le modèle issu du traitement précité afin de déterminer quels logements sont potentiellement autoconsommateurs.

Comme illustré sur la figure 1, les logements L1, L2, ..., Ln dans un secteur alimenté par une branche basse tension BT sont équipés de compteurs communicants C1, C2, ..., Cn, capables de communiquer avec un serveur SER, via un réseau RES (par exemple par courants porteurs en ligne). Le serveur SER reçoit en outre des données météorologiques depuis la station MET. Comme illustré en outre sur la figure 1, des logements (ici L1 et Ln) sont équipés de moyens de production autonome comme des panneaux photovoltaïques (PV1, ..., PVn). Le serveur SER comporte quant à lui un module de traitement MOD dont les fonctionnalités sont présentées plus loin, coopérant avec une mémoire MEM organisée comme une base de données pour stocker des données issues du module MOD, ces données pouvant être typiquement :

- une information de présence (AUT) ou non (N-AUT) de moyen autonome pour chaque logement, présence détectée par le module MOD comme détaillé plus loin,
- en correspondance de coordonnées de contact de ce logement (ID CT1, ID CT2, ..., ID CTn).

Ces coordonnées de contact peuvent être par exemple :

- des coordonnées téléphoniques, et/ou
- une adresse numérique (de messagerie type courriel ou autre), et/ou
- une adresse physique de correspondance.

Une fois le traitement opéré par le module MOD, la mémoire MEM peut alors être consultée pour déterminer, avant une opération sur un secteur comportant les logements L1, L2, ..., Ln :

- si certains logements sont équipés de moyens de production autonome, et
- le cas échéant, initier un message à destination des coordonnées de contact précitées, pour prévenir d'une intervention future sur le secteur de ces logements, et demandant aux utilisateurs des moyens de production autonome de couper ces derniers pendant la durée de l'intervention.

Dans une variante où le personnel intervenant peut couper lui-même les moyens de production autonomes, la mémoire MEM stocke, en correspondance de l'information de présence de moyen autonome, des coordonnées d'adresse physique de chaque logement. Ainsi, la mémoire MEM peut alors être consultée pour déterminer, avant une opération sur un secteur comportant les logements L1, L2, ..., Ln :

- si certains logements sont équipés de moyens de production autonome, et
- le cas échéant, initier un message à destination du personnel intervenant, pour prévenir de la présence de tels moyens autonomes dans des logements (L1, ..., Ln) dont l'adresse est spécifiée dans le message.

La liste des logements équipés de moyens autonomes peut ainsi être transmise aux agents chargés de l'intervention, lesquels sont donc en mesure de cibler leur recherche. Cette démarche leur permet de ne pas perdre du temps à inspecter chaque logement alimenté par le poste BT en question afin de trouver quel logement est isolé du réseau.
Dans une autre variante encore, une coupure à distance des compteurs communicants C1, ..., Cn, peut être opérée dans l'ordre décroissant de probabilités d'être installé dans un logement autoconsommateur non déclaré tant que la tension mesurée sur le réseau est non nulle. Dans ce cas, la mémoire MEM stocke une base de données avec des identifiants de compteurs (ID C1, ID C2, ..., ID Cn) en correspondance d'une information de présence ou non d'un moyen autonome, ou encore d'un score de probabilité de présence d'un moyen autonome dans chaque logement L1, L2, ..., Ln.
En effet, dans le cas d'une intervention programmée sur le réseau, ou sur les parties non coupées dans le cas d'une coupure, il est possible de couper à distance les compteurs notamment en baissant la puissance de coupure des compteurs. Ainsi, on peut couper en avance les compteurs de logements ayant une probabilité supérieure à un certain seuil p d'être autoconsommateur non déclaré. Lors de la mise hors tension, il est toujours possible qu'il y ait encore une tension mesurée non nulle, et on pourrait décider de réalimenter le poste pour couper encore des compteurs supplémentaires.
De manière générale, la donnée qui est stockée dans la base MEM en correspondance de l'information de moyen de production autonome peut être ainsi :

- une coordonnée de contact d'un utilisateur du logement,
- une adresse physique du logement,
- ou encore un identifiant du compteur présent dans le logement.

Cette donnée est désignée plus généralement comme étant un « identifiant propre au logement » (à l'utilisateur du logement, à son compteur, au logement lui-même, et/ou autre).
On a illustré sur la figure 2, un exemple de succession d'étapes dans un procédé où les compteurs sont coupés à distance. Dans cette réalisation, on tire à l'étape S1 depuis la mémoire MEM, une liste de scores de probabilité de présence de moyens autonomes dans des logements respectifs équipés de compteurs respectifs d'identifiants ID C1, ID C2, ..., ID Cn. A l'étape S2 (pouvant être réalisée répétitivement), on mesure la tension sur la branche BT sur laquelle l'intervention est prévue. Si la tension est nulle (ou inférieure à un seuil en valeur absolue) un message peut être émis à l'étape S5, à destination de l'équipe d'intervention pour confirmer l'intervention. En revanche, si la tension n'est pas nulle (flèche KO en sortie du test S2), alors le compteur correspondant au score maximum MAX(SCO) dans la liste issue de la base MEM, est coupé à l'étape S3. Ce score maximum MAX(SCO) est retiré de la liste en vue d'une nouvelle itération où l'on vérifie à nouveau si la tension sur le secteur BT est nulle. On réitère ainsi les étapes S2, S3 et S4 jusqu'à ce que la tension mesurée soit nulle.
Ce procédé (automatisé par des moyens informatiques tels qu'un circuit de traitement prévu dans le serveur SER et équipé d'un processeur) permet de gagner du temps d'intervention et d'assurer la sécurité des intervenants sur le réseau.
On décrit ci-après le fonctionnement du module MOD, d'apprentissage-prévision, ainsi alimenté par les données de consommation issues des compteurs C1, C2, ... Cn, et par les données de la station MET du secteur géographique des logements L1, ..., Ln. Le module prédit une probabilité d'autoconsommation dans chaque logement du secteur BT comme suit.
On peut à cet effet considérer deux approches :

- Une première approche dite de type « boosting d'arbres » nécessitant une construction de variables (ou « feature engineering »),

- Une deuxième approche basée sur un apprentissage profond (ou « deep learning »).

Pour mettre en place le modèle selon la première approche, on dispose d'un échantillon d'apprentissage, composé de logements avec les variables suivantes renseignées :

- La variable à prédire indiquant si le logement est autoconsommateur ou non ;
- La consommation (demi-horaire ou horaire ou journalière sur plusieurs jours) du logement ;
- L'irradiance et/ou la force du vent, données par la station météorologique la plus proche ;
- La température donnée par la station météorologique la plus proche, pour identifier des consommations liées à des besoins thermiques (chauffage ou climatisation).

On effectue ensuite une construction de variables explicatives à partir des variables listées ci-dessus pour discriminer le phénomène à observer, ces variables pouvant être par exemple:

- Le ratio moyen par client entre la consommation entre 10 et 16h et la consommation totale du jour (un individu potentiellement producteur possédant un ratio inférieur à un individu non producteur),
- Dans le cas où l'on cherche à détecter la présence de panneaux photovoltaïques, la pente de la ligne de régression de la consommation entre 12h et 14h par le rayonnement est encore une variable explicative. En effet, plus le rayonnement est fort et plus le niveau de la consommation est faible (la production est plus importante).
- Le ratio entre la consommation moyenne entre 10h et 16h pour les X jours à plus forts rayonnements et celle entre 10h et 16h pour les X jours à plus faibles rayonnements. X dépend de l'historique disponible.
- Le ratio moyen par client entre la consommation entre 10 et 16h et les degrés-jours entre 10h et 16h.
- Le ratio moyen de la consommation par degrés-jours entre 10h et 16h pour les X jours à plus forts rayonnements et la consommation par degrés-jours entre 10h et 16h pour les X jours à plus faibles rayonnements.

Dans le cas où seules des consommations journalières sont disponibles, les variables créées peuvent être les suivantes :

- Le ratio consommation jour sur rayonnement jour ;
- Le ratio consommation jour sur rayonnement moyen entre 10h et 16h ;
- Le ratio consommation jour sur rayonnement moyen entre 12h et 14h ;
- Le ratio consommation jour sur rayonnement maximum entre 10h et 16h ;
- Le ratio consommation jour sur rayonnement maximum entre 12h et 14h ;
- Le ratio entre la consommation moyenne jour pour les X jours à plus forts rayonnements et celle pour les X jours à plus faibles rayonnements ;
- Le ratio moyen consommation jour sur degrés-jour ;
- Le ratio moyen de la consommation jour par degrés-jours pour les X jours à plus forts rayonnements et la consommation jour par degrés-jours pour les X jours à plus faibles rayonnements.

Ces variables ont été définies car elles minimisaient les erreurs de prédiction lors de tests effectués par la Demanderesse.

Une fois les variables explicatives obtenues, le modèle selon la méthode du « boosting » d'arbres peut être estimé pour expliquer le fait d'être autoconsommateur ou non.

Le « boosting » d'arbres peut s'écrire mathématiquement de la manière suivante à partir d'un premier modèle de type :

[Math. 1]

$$y_t = M_1(x_t) + \varepsilon_{1,t}$$

où $y_t$ est la variable à prédire et $M_1$ un arbre de régression, la différence $\varepsilon_{1,t}$ étant l'erreur issue du modèle.

Le principe du « boosting » d'arbres consiste dans un premier temps à estimer l'erreur issue du modèle ci-dessus par la formule :

[Math. 2]

$$\hat{\varepsilon}_{1,t} = y_t - \widehat{M}_1(x_t)$$

Dans un second temps, on cherche à modéliser l'erreur estimée ci-dessus par un deuxième arbre :

[Math. 3]

$$\hat{\varepsilon}_{1,t} = M_2(x_t) + \varepsilon_{2,t}$$

On continue ainsi de suite à modéliser les erreurs des modèles successifs jusqu'à vérifier un critère d'arrêt choisi.
A la fin, la prédiction est obtenue de la manière suivante:

[Math. 4]

$$\hat{y}_t = \widehat{M}_1(x_t) + \widehat{M}_2(x_t) + \cdots + \widehat{M}_k(x_t)$$

où k est le nombre d'arbres appris.
L'estimation du modèle selon la méthode du « boosting » d'arbres peut se poursuivre ensuite par de l'affinage de paramètres comme le nombre d'arbres, la profondeur maximum des arbres, le pourcentage de l'échantillon d'apprentissage utilisé, etc. Pour estimer ces paramètres, des validations croisées peuvent être effectuées. Une validation croisée consiste à partager l'échantillon en L parties. Pour chaque partie L, le modèle est appris sur les L-1 autres parties, puis testé sur la partie L. On réalise donc L apprentissage et L validations du modèle, jusqu'à ce qu'il soit possible d'estimer l'erreur de généralisation du modèle avec ce jeu de paramètres. On choisit finalement le jeu de paramètres minimisant l'erreur en validation croisée.
Une fois le modèle appris, le module MOD peut appliquer le modèle en relevant l'historique disponible dans les compteurs communicants d'une part, et les données météorologiques d'autre part. En particulier, on calcule par exemple un score de probabilité de présence d'un panneau photovoltaïque en fonction notamment des variables donnant une consommation basse entre 10 et 16h et plus particulièrement entre 12 et 14h, pour des jours ensoleillés.
La deuxième approche, d'apprentissage profond, peut commencer par constituer un échantillon d'apprentissage en utilisant possiblement les mêmes variables que celles utilisées dans la méthode du « boosting » d'arbres ci-avant (consommation jour, irradiance moyenne jour, irradiance maximum du jour, irradiance moyenne 12h-16h et degrés-jours, par exemple). Au lieu d'utiliser un réseau pleinement connecté comme il est habituel pour résoudre ce genre de problème, on utilise ici le principe des réseaux convolutifs pour détecter des formes sur les courbes de charge issues des compteurs et la température locale, ainsi que des corrélations.
Par exemple, l'historique de chaque client peut être découpé sur des périodes de sept jours afin d'augmenter artificiellement le nombre de données, la convergence des poids des réseaux de neurones nécessitant beaucoup de données.
La première couche du réseau consiste en une couche de convolution consistant à appliquer n filtres sur chaque observation (consistant au vecteur des sept jours de consommation d'un client de l'échantillon). Les filtres appliqués sont de profondeur 4 (pour quatre variables en entrées : température, irradiance entre 12 et 16h ici, irrandiance du jour, consommation du jour) et de taille 1 *1.
A la suite de chaque filtre, la fonction d'activation est une fonction Relu :

[Math. 5]

$$f(x) = \begin{matrix} x \; si \; x > 0 \\ 0 \; si \; x \leq 0 \end{matrix}$$

Les valeurs des filtres autrement appelés les poids sont appris par le réseau convolutif selon l'algorithme dit de « back propagation » du gradient. Les poids sont ensuite normalisés par la méthode d'Adam.

Après la première étape de convolution, on applique une étape de Max Pooling de taille 7. Il ne reste donc plus qu'une valeur par variable d'entrée, par observation et par filtre.

Les sorties du Pooling sont ensuite branchées à un réseau dont l'architecture globale est illustrée sur la figure 3. Le réseau est pleinement connecté avec un nombre de couches cachées variant en fonction des données. Le réseau se termine par une couche Softmax afin de discriminer les autoconsommateurs non déclarés des autres clients (deux sorties par exemple).

Bien entendu, la présente invention ne se limite pas aux formes de réalisation présentées ci-avant à titre d'exemple ; elle s'étend à d'autres variantes.

Par exemple, un autre problème que pourrait résoudre l'invention concerne le reflux sur les réseaux BT lorsque la production solaire dépasse la consommation à l'échelle d'un poste BT, un trop grand déséquilibre pouvant amener à des coupures électriques sur le réseau. Dans le cas de reflux important sur le réseau, certaines solutions sont à l'heure actuelle en cours de test comme installer des batteries sur le réseau. Cependant, il s'agit toujours de solutions globales (introduction de batteries au niveau du réseau par exemple) et souvent coûteuses et non ciblées sur les quelques clients générant le reflux. Identifier les autoproducteurs non déclarés permettrait de mieux adapter les solutions à apporter : par exemple leur proposer des solutions de stockage particulières (ballon d'eau chaude sanitaire, batterie ou autre), de déplacement de leurs usages, de vendre leur énergie à d'autres clients ou proposer un ilotage en cas de reflux sur le réseau trop important.

Ainsi l'invention permet de détecter automatiquement les autoconsommateurs non déclarés sur un secteur afin de :

- Sécuriser l'intervention des agents,
- diminuer les temps d'intervention,
- et éventuellement sécuriser le réseau en cas de reflux trop important des autoconsommateurs non déclarés.

**Revendications**

1. Procédé de sécurisation de personnes devant effectuer une intervention sur une branche basse tension d'un réseau de distribution d'électricité, dans lequel :

   la branche basse tension est reliée à un poste alimentant une pluralité de logements dans un secteur géographique,
   les logements sont équipés de compteurs (C1, ..., Cn) configurés pour mesurer et communiquer des consommations par pas de temps réguliers,
   une partie au moins des logements est susceptible de comporter des moyens autonomes de production d'électricité (PV1, ..., PVn) par usage d'énergie renouvelable, une mise en service desdits moyens autonomes générant une tension électrique dans la branche basse tension, malgré une coupure du poste d'alimentation pendant l'intervention, et mettant ainsi en danger les personnes pendant leur intervention,
   le procédé, mis en oeuvre par un serveur communiquant avec les compteurs, étant **caractérisé en ce qu'**il comporte les étapes :

   - obtenir des premières données, de relevés de consommations issus de chaque compteur par pas de temps réguliers,
   - obtenir des deuxièmes données (MET), météorologiques dans le secteur géographique, pour identifier au moins des conditions propices à la production d'énergie par lesdits moyens autonomes,
   - pour chaque compteur, appliquer un modèle de détection, en fonction au moins des premières et deuxièmes données, d'une coïncidence entre des périodes de baisse de consommation mesurée par le compteur et des conditions météorologiques propices à la production électrique par lesdits moyens autonomes pendant lesdites périodes, et déduire de l'application du modèle une information de présence de moyens autonomes dans le logement équipé de ce compteur,
   - stocker dans une base de données (MEM) l'information de présence de moyens autonomes en correspondance d'un identifiant propre au logement, pour chaque logement,
   - et, avant l'intervention, identifier dans la base de données les logements susceptibles de comporter des moyens autonomes (S1).

2. Procédé selon la revendication 1, **caractérisé en ce que** le serveur obtient en outre une mesure instantanée de la tension sur la branche basse tension, avant l'intervention, et l'intervention est conditionnée par l'obtention au serveur d'une mesure de tension nulle sur la branche basse tension (S2, S5).

**3.** Procédé selon la revendication 2, dans lequel chaque compteur est configuré pour être coupé à distance, par commande du serveur, le procédé étant **caractérisé en ce que** l'information de présence est un score de probabilité de présence de moyens autonomes dans le logement équipé de ce compteur, et **en ce que** le procédé comporte en outre les étapes :

- établir une liste (S1) des scores de probabilité de présence de moyens autonomes, en correspondance d'identifiants de compteurs respectifs,
- en cas d'obtention d'une tension mesurée comme non nulle sur la branche basse tension (S2), utiliser l'identifiant de compteur ayant le score maximum dans ladite liste pour couper à distance ce compteur (S3), puis supprimer ce compteur de la liste (S4) et réitérer cette étape jusqu'à obtention d'une mesure de tension nulle sur la branche (S5).

**4.** Procédé selon l'une des revendications précédentes, **caractérisé en ce que** le modèle de détection est obtenu par une technique de « boosting d'arbres » comprenant :

- un renseignement de variables dans un échantillon d'apprentissage composé de logements dont les consommations sont analysées,
- une définition de variables explicatives de la corrélation, tirées des variables renseignées, et
- une application de la méthode de boosting d'arbres aux variables explicatives pour déterminer un modèle de calcul d'un score de probabilité de présence de moyens autonomes dans un logement équipé d'un compteur mesurant et communiquant des consommations dans le logement par pas de temps réguliers, ledit score correspondant à ladite information de présence stockée dans la base de données.

**5.** Procédé selon la revendication 4, **caractérisé en ce qu'**une validation croisée est appliquée en outre pour consolider la détermination du modèle de calcul.

**6.** Procédé selon l'une des revendications 1 à 3, **caractérisé en ce que** le modèle de détection est obtenu par la mise en oeuvre d'un réseau de neurones convolutifs, cette mise en oeuvre comprenant :

- un renseignement de variables dans un échantillon d'apprentissage composé de logements dont les consommations sont analysées,
- un apprentissage par le réseau de neurones de l'échantillon, et
- la détermination par le réseau de neurones d'un modèle de calcul d'un score de probabilité de présence de moyens autonomes dans un logement équipé d'un compteur mesurant et communiquant des consommations dans le logement par pas de temps réguliers, ledit score correspondant à ladite information de présence stockée dans la base de données.

**7.** Procédé selon l'une des revendications 4 à 6, **caractérisé en ce que** les variables à renseigner dans l'échantillon d'apprentissage, comportent, pour chaque logement :

- Une variable à prédire en tant que telle, indiquant si le logement est équipé de moyen de production autonome ou non ;
- La consommation du logement par pas régulier ;
- Des conditions météorologiques dans le secteur de ce logement, incluant une température instantanée dans ce secteur.

**8.** Procédé selon l'une des revendications précédentes, dans lequel le moyen de production autonome dont on cherche à détecter la présence est un panneau photovoltaïque, **caractérisé en ce que** les conditions météorologiques incluent au moins un degré d'ensoleillement à un instant donné.

**9.** Procédé selon la revendication 7, prise en combinaison avec la revendication 8 et avec l'une des revendications 3 et 4, dans lequel chaque compteur est agencé pour mesurer et communiquer des consommations à un pas horaire ou infra-horaire, **caractérisé en ce que** les variables explicatives comportent au moins une variable parmi:

- Un ratio moyen par compteur entre une consommation entre 10 heures et 16 heures d'une journée et une consommation totale sur la même journée complète,
- Une pente de ligne de régression de la consommation entre 12 heures et 14 heures par degré ensoleillement,
- Un ratio entre une consommation moyenne sur l'ensemble des compteurs entre 10 heures et 16 heures pour les X jours à plus forts degrés d'ensoleillement et celle entre 10 heures et 16 heures pour les X jours à plus faibles degrés d'ensoleillement,
- Un ratio moyen par compteur entre la consommation entre 10 et 16 heures et les degrés en température du même jour entre 10 et 16 heures,
- Un ratio moyen de consommation par degré de température entre 10 et 16 heures pour les X jours à plus forts degrés d'ensoleillement et une consommation par degré de température entre 10 et 16 heures pour les X jours à plus faibles degrés d'ensoleillement.

10. Procédé selon la revendication 7, prise en combinaison avec la revendication 8 et avec l'une des revendications 3 et 4, dans lequel chaque compteur est agencé pour mesurer et communiquer des consommations à un pas journalier, **caractérisé en ce que** les variables explicatives comportent au moins une variable parmi:

- Un ratio de consommation sur une journée par degré d'ensoleillement sur la même journée ;
- Un ratio de consommation sur une journée par degré d'ensoleillement moyen entre 10 et 16 heures de cette journée ;
- Un ratio de consommation sur une journée par degré d'ensoleillement moyen entre 12 et 14 heures de cette journée ;
- Un ratio de consommation sur une journée par degré d'ensoleillement maximum entre 10 et 16 heures de cette journée ;
- Un ratio de consommation sur une journée par degré d'ensoleillement maximum entre 12 et 14 heures de cette journée;
- Un ratio entre la consommation moyenne par jour pour les X jours à plus forts degrés d'ensoleillement et la consommation moyenne pour les X jours à plus faibles degrés d'ensoleillement ;
- Un ratio moyen de consommation par jour par degrés de température ;
- Un ratio moyen entre la consommation par jour par degré de température pour les X jours à plus forts degrés d'ensoleillement et une consommation par jour par degré de température pour les X jours à plus faibles degrés d'ensoleillement.

11. Programme informatique comportant des instructions pour la mise en oeuvre du procédé selon l'une des revendications 1 à 10, lorsque lesdites instructions sont exécutées par un processeur d'un module de traitement (MOD).

12. Module de traitement (MOD) configuré pour mettre en oeuvre les étapes suivantes :

- obtenir des premières données, de relevés de consommations issus compteurs par pas de temps réguliers,
- obtenir des deuxièmes données (MET), météorologiques dans un secteur géographique, pour identifier au moins des conditions propices à la production d'énergie par des moyens autonomes,
- pour chaque compteur, appliquer un modèle de détection, en fonction au moins des premières et deuxièmes données, d'une coïncidence entre des périodes de baisse de consommation mesurée par le compteur et des conditions météorologiques propices à la production électrique par lesdits moyens autonomes pendant lesdites périodes, et déduire de l'application du modèle une information de présence de moyens autonomes dans un logement équipé de ce compteur,

le module comportant une sortie (OUT) pour alimenter la base de données stockée dans la mémoire (MEM) d'un serveur (SER).

13. Serveur comportant un module de traitement (MOD) selon la revendication 12 et ladite mémoire (MEM).


**Patentansprüche**

1. Verfahren zur Sicherung von Personen, die einen Eingriff an einem Niederspannungszweig eines Stromverteilungsnetzes vornehmen sollen, wobei:

der Niederspannungszweig mit einer Station verbunden ist, die eine Vielzahl von Wohnungen in einem geografischen Gebiet versorgt,
die Wohnungen mit Zählern (C1, ..., Cn) ausgestattet sind, die dazu ausgebildet sind, den Verbrauch in regelmäßigen Zeitschritten zu messen und zu melden,
wenigstens ein Teil der Wohnungen autonome Mittel zur Stromerzeugung (PV1, ..., PVn) durch Nutzung erneuerbarer Energie aufweisen kann, wobei eine Inbetriebnahme dieser autonomen Mittel trotz einer Unterbrechung der Versorgungsstation während des Eingriffs eine elektrische Spannung im Niederspannungszweig erzeugt und somit die Personen während ihres Eingriffs gefährdet,

das Verfahren, das von einem mit den Zählern kommunizierenden Server implementiert wird, **dadurch gekennzeichnet ist, dass** es die folgenden Schritte umfasst:

- Erhalten erster Daten, Verbrauchswerte, die von jedem Zähler in regelmäßigen Zeitschritten erhalten werden,
- Erhalten zweiter Daten (MET), meteorologische Daten, in dem geografischen Gebiet, um wenigstens Bedingungen zu identifizieren, die für die Energieerzeugung durch die autonomen Mittel geeignet sind,
- für jeden Zähler, basierend wenigstens auf den ersten und zweiten Daten, Anwenden eines Modells zur Erkennung einer Koinzidenz zwischen Perioden des vom Zähler gemessenen Verbrauchsrückgangs und meteorologischer Bedingungen, die für die Stromerzeugung durch die autonomen Mittel während dieser Perioden günstig sind, und Ableitung einer Information über das Vorhandensein autonomer Mittel in der mit diesem Zähler ausgestatteten Wohnung aus der Anwendung des Modells,
- Speichern der Information zum Vorhandensein von autonomen Mitteln in einer Datenbank (MEM) in Entsprechung zu einer wohnungsspezifischen Kennung für jede Wohnung,
- und, vor dem Eingriff, Identifizieren der Wohnungen, die möglicherweise über autonome Mittel (S1) verfügen, in der Datenbank.

2. Verfahren nach Anspruch 1, **dadurch gekennzeichnet, dass** der Server vor dem Eingriff ferner eine momentane Messung der Spannung auf dem Niederspannungszweig erhält und der Eingriff dadurch bedingt ist, dass der Server eine Nullspannungsmessung auf dem Niederspannungszweig erhält (S2, S5).

3. Verfahren nach Anspruch 2, wobei jeder Zähler dazu ausgebildet ist, auf Befehl des Servers aus der Ferne abgeschaltet zu werden, wobei das Verfahren **dadurch gekennzeichnet ist, dass** die Vorhandenseins-Information ein Wahrscheinlichkeitswert für das Vorhandensein von autonomen Mitteln in der mit diesem Zähler ausgestatteten Wohnung ist, und dass das Verfahren ferner die folgenden Schritte umfasst:

- Erstellen einer Liste (S1) der Wahrscheinlichkeitswerte für das Vorhandensein von autonomen Mitteln, entsprechend den Kennungen der jeweiligen Zähler,
- im Falle des Erhalts einer als nicht null gemessenen Spannung auf dem Niederspannungszweig (S2), Verwenden der Kennung des Zählers mit der höchsten Punktzahl in der Liste, um diesen Zähler ferngesteuert abzuschalten (S3), dann Entfernen dieses Zählers aus der Liste (S4) und Wiederholen dieses Schritts, bis eine Nullspannungsmessung auf dem Zweig (S5) erhalten wird.

4. Verfahren nach einem der vorhergehenden Ansprüche, **dadurch gekennzeichnet, dass** das Erkennungsmodell durch eine "Tree-Boosting"-Methode erhalten wird, umfassend:

- Daten zu Variablen in einer Teststichprobe, die Wohnungen umfasst, deren Verbrauch analysiert wird,
- eine Definition der erklärenden Variablen der Korrelation, die aus den gelieferten Variablen abgeleitet werden, und
- eine Anwendung der Tree-Boosting-Methode auf die erklärenden Variablen, um ein Modell zur Berechnung eines Wahrscheinlichkeitswertes für das Vorhandensein von autonomen Mitteln in einer Wohnung zu bestimmen, die mit einem Zähler ausgestattet ist, der den Verbrauch in der Wohnung in regelmäßigen Zeitschritten misst und meldet, wobei der Wert der in der Datenbank gespeicherten Vorhandenseins-Information entspricht.

5. Verfahren nach Anspruch 4, **dadurch gekennzeichnet, dass** ferner eine Kreuzvalidierung angewendet wird, um die Bestimmung des Berechnungsmodells zu konsolidieren.

6. Verfahren nach einem der Ansprüche 1 bis 3, **dadurch gekennzeichnet, dass** das Erkennungsmodell durch die Implementierung eines Netzes faltungskodierter Neuronen erhalten wird, wobei diese Implementierung umfasst:

- Daten zu Variablen in einer Teststichprobe, die Wohnungen umfasst, deren Verbrauch analysiert wird,
- Beherrschen der Stichprobe durch das neuronale Netz, und
- die Bestimmung eines Modells durch das neuronale Netz zur Berechnung eines Wahrscheinlichkeitswertes für das Vorhandensein autonomer Mittel in einer Wohnung, die mit einem Zähler ausgestattet ist, der den Verbrauch in der Wohnung in regelmäßigen Zeitschritten misst und meldet, wobei der Wert der in der Datenbank gespeicherten Vorhandenseins-Information entspricht.

7. Verfahren nach einem der Ansprüche 4 bis 6, **dadurch gekennzeichnet, dass** die Variablen in der Trainingsstichprobe für jede Wohnung beinhalten:

   - eine Variable, die als solche vorhergesagt werden soll und die angibt, ob die Wohnung mit einem autonomen Erzeugungsmittel ausgestattet ist oder nicht;
   - den Verbrauch der Wohnung in regelmäßigen Schritten;
   - meteorologische Bedingungen in dem Gebiet der Wohnung, einschließlich der momentanen Temperatur in diesem Gebiet.

8. Verfahren nach einem der vorhergehenden Ansprüche, wobei das autonome Erzeugungsmittel, dessen Vorhandensein festgestellt werden soll, ein Photovoltaikmodul ist, **dadurch gekennzeichnet, dass** die meteorologischen Bedingungen wenigstens einer Sonneneinstrahlungsintensität zu einem gegebenen Zeitpunkt beinhalten.

9. Verfahren nach Anspruch 7 in Kombination mit Anspruch 8 und einem der Ansprüche 3 oder 4, wobei jeder Zähler dazu angeordnet ist, den Verbrauch in stündlichen oder unterstündlichen Schritten zu messen und zu melden, **dadurch gekennzeichnet, dass** die erklärenden Variablen wenigstens eine der folgenden Variablen umfassen:

   - ein durchschnittliches Verhältnis pro Zähler zwischen einem Verbrauch zwischen 10 Uhr und 16 Uhr eines Tages und einem Gesamtverbrauch an demselben gesamten Tag,
   - eine Steigung der Regressionslinie des Verbrauchs zwischen 12 und 14 Uhr pro Sonneneinstrahlungsintensität,
   - ein Verhältnis zwischen einem durchschnittlichen Verbrauch aller Zähler zwischen 10:00 und 16:00 Uhr an den X Tagen mit den höchsten Sonneneinstrahlungsintensitäten und dem Verbrauch zwischen 10:00 und 16:00 Uhr an den X Tagen mit den niedrigsten Sonneneinstrahlungsintensitäten,
   - ein durchschnittliches Verhältnis pro Zähler zwischen dem Verbrauch zwischen 10 und 16 Uhr und den Temperaturgraden desselben Tages zwischen 10 und 16 Uhr,
   - ein durchschnittliches Verhältnis von Verbrauch pro Temperaturgrad zwischen 10 und 16 Uhr an den X Tagen mit den höchsten Sonneneinstrahlungsintensitäten und Verbrauch pro Temperaturgrad zwischen 10 und 16 Uhr an den X Tagen mit den niedrigsten Sonneneinstrahlungsintensitäten.

10. Verfahren nach Anspruch 7 in Kombination mit Anspruch 8 und einem der Ansprüche 3 oder 4, wobei jeder Zähler dazu angeordnet ist, den Verbrauch in Tagesschritten zu messen und zu melden, **dadurch gekennzeichnet, dass** die erklärenden Variablen wenigstens eine der folgenden Variablen umfassen:

   - ein Verhältnis von Tagesverbrauch zu Sonneneinstrahlungsintensität an demselben Tag;
   - ein Verhältnis von Tagesverbrauch zu durchschnittlicher Sonneneinstrahlungsintensität zwischen 10 und 16 Uhr an diesem Tag;
   - ein Verhältnis von Tagesverbrauch zu durchschnittlicher Sonneneinstrahlungsintensität zwischen 12 und 14 Uhr an diesem Tag;
   - ein Verhältnis von Tagesverbrauch zu maximaler Sonneneinstrahlungsintensität zwischen 10 und 16 Uhr an diesem Tag;
   - ein Verhältnis von Tagesverbrauch zu maximaler Sonneneinstrahlungsintensität zwischen 12 und 14 Uhr an diesem Tag;
   - ein Verhältnis zwischen durchschnittlichem Tagesverbrauch an den X Tagen mit den höchsten Sonneneinstrahlungsintensitäten und durchschnittlichem Tagesverbrauch an den X Tagen mit den niedrigsten Sonneneinstrahlungsintensitäten;
   - ein durchschnittliches Verhältnis des Verbrauchs pro Tag nach Temperaturgraden;
   - ein durchschnittliches Verhältnis von Tagesverbrauch pro Temperaturgrad für die X Tage mit den höchsten Sonneneinstrahlungsintensitäten und Tagesverbrauch pro Temperaturgrad für die X Tage mit den niedrigsten Sonneneinstrahlungsintensitäten.

11. Computerprogramm, umfassend Anweisungen zur Durchführung des Verfahrens nach einem der Ansprüche 1 bis 10, wenn die Anweisungen von einem Prozessor eines Verarbeitungsmoduls (MOD) ausgeführt werden.

12. Verarbeitungsmodul (MOD), welches dazu ausgebildet ist, die folgenden Schritte durchzuführen:

   - Erhalten erster Daten, die aus Verbrauchsmessungen von Zählern in regelmäßigen Zeitschritten stammen,

- Erhalten zweiter Daten (MET), meteorologischer Daten in einem geografischen Gebiet, um wenigstens Bedingungen zu identifizieren, die für die Energieerzeugung durch autonome Mittel geeignet sind,
- für jeden Zähler, basierend auf wenigstens den ersten und zweiten Daten, Anwenden eines Modells zum Erkennen einer Koinzidenz zwischen Perioden des vom Zähler gemessenen Verbrauchsrückgangs und meteorologischen Bedingungen, die für die Stromerzeugung durch die genannten autonomen Mittel während dieser Perioden günstig sind, und Ableiten einer Information zum Vorhandensein von autonomen Mitteln in einer mit diesem Zähler ausgestatteten Wohnung aus der Anwendung des Modells,

wobei das Modul einen Ausgang (OUT) aufweist, um die im Speicher (MEM) eines Servers (SER) gespeicherte Datenbank zu versorgen.

**13.** Server, umfassend ein Verarbeitungsmodul (MOD) nach Anspruch 12 und dem Speicher (MEM).

**Claims**

**1.** Method for ensuring the safety of persons needing to service a low-voltage network of an electric power distribution system, wherein:

the low-voltage network is connected to a substation supplying power to a plurality of dwellings within a geographical area,
the dwellings are equipped with meters (C1, ..., Cn) configured to measure and communicate consumption by regular time intervals,
at least some of the dwellings are likely to comprise autonomous means of producing electricity (PV1, ..., PVn) using renewable energy, a placing in operation of said autonomous means generating voltage in the low-voltage network despite shutting down the substation during the work, thus endangering people during their intervention, the method, implemented by a server communicating with the meters, being **characterized in that** it comprises the steps of:

- obtaining first data from consumption records from each meter by regular time intervals,
- obtaining second data (MET) which are meteorological data in the geographical area, in order to identify at least some weather conditions conducive to the production of energy by said autonomous means,
- for each meter, applying a model for detecting, based on at least the first and second data, a coincidence between periods of low consumption measured by the meter and weather conditions conducive to electricity production by said autonomous means during said periods, and deducing, from the application of the model, information on the presence of autonomous means in the dwelling equipped with this meter,
- for each dwelling, storing in a database (MEM) the information on the presence of autonomous means, with a corresponding identifier specific to the dwelling,
- and, before performing the servicing work, identifying in the database the dwellings likely to comprise autonomous means (S1).

**2.** Method according to Claim 1, wherein the server further obtains an instantaneous measurement of the voltage in the low-voltage network before the servicing work, and the work is dependent on the server obtaining a zero-voltage measurement in the low-voltage network (S2, S5).

**3.** Method according to claim 2, wherein each meter is configured to be cut off remotely by a command from the server, the method being **characterized in that** the presence information is a probability score for the presence of autonomous means in the dwelling equipped with said meter, and **in that** the method further comprises the steps of:

- establishing a list (S1) of the probability scores for the presence of autonomous means, with respective corresponding meter identifiers,
- if a non-zero voltage is measured in the low-voltage network (S2), using the meter identifier having the maximum score in said list to cut off that meter (S3) remotely, then removing that meter from the list (S4) and repeating this step until a zero-voltage measurement is obtained in the network (S5).

**4.** Method according to one of the preceding claims, wherein the detection model is obtained by a "tree boosting" technique comprising:

- a setting of variables in a learning sample composed of dwellings for which the consumption is analyzed,
- a defining of explanatory variables of the correlation, taken from the variables set, and
- an application of the tree boosting method to the explanatory variables in order to determine a model for calculating a probability score for the presence of autonomous means in a dwelling equipped with a meter measuring and communicating consumption in the dwelling by regular time intervals, said score corresponding to said presence information stored in the database.

5. Method according to claim 4, wherein a cross-validation is further applied in order to consolidate the determination of the calculation model.

6. Method according to one of claims 1 to 3, wherein the detection model is obtained by implementing a convolutional neural network, this implementation comprising:

    - a setting of variables in a learning sample composed of dwellings for which the consumption is analyzed,
    - a learning of the sample by the neural network, and
    - the determination by the neural network of a model for calculating a probability score for the presence of autonomous means in a dwelling equipped with a meter measuring and communicating consumption in the dwelling by regular time intervals, said score corresponding to said presence information stored in the database.

7. Method according to one of claims 4 to 6, wherein the variables to be set in the learning sample comprise, for each dwelling:

    - a predictive variable indicating whether or not the dwelling is equipped with autonomous production means;
    - the dwelling consumption, by regular intervals;
    - the weather conditions in the area of the dwelling, including an instantaneous temperature in this area.

8. Method according to one of the preceding claims, wherein the autonomous production means whose presence is to be detected is a photovoltaic panel, **characterized in that** the weather conditions include at least the level of sunlight at a given moment.

9. Method according to claim 7, in combination with claim 8 and with one of claims 3 and 4, wherein each meter is arranged to measure and communicate consumption at an hourly or sub-hourly interval, **characterized in that** the explanatory variables comprise at least one variable among:

    - an average ratio per meter between a consumption between 10 a.m. and 4 p.m. in a day and a total consumption over the same full day,
    - a slope of the regression line of the consumption between 12 p.m. and 2 p.m. versus level of sunlight,
    - a ratio between an average consumption over all meters between 10 a.m. and 4 p.m. for the X days with higher levels of sunlight and that between 10 a.m. and 4 p.m. for the X days with lower levels of sunlight,
    - an average ratio per meter between the consumption between 10 a.m. and 4 p.m. and the degrees of temperature for the same day between 10 a.m. and 4 p.m.,
    - an average ratio of consumption per degree of temperature between 10 a.m. and 4 p.m. for the X days with higher levels of sunlight and consumption per degree of temperature between 10 a.m. and 4 p.m. for the X days with lower levels of sunlight.

10. Method according to claim 7, in combination with claim 8 and with one of claims 3 and 4, wherein each meter is arranged to measure and communicate consumption at a daily interval, **characterized in that** the explanatory variables comprise at least one variable among:

    - a ratio of consumption over one day to level of sunlight over the same day;
    - a ratio of consumption over one day to average level of sunlight between 10 a.m. and 4 p.m. of that day;
    - a ratio of consumption over one day to average level of sunlight between 12 p.m. and 2 p.m. of that day;
    - a ratio of consumption over one day to maximum level of sunlight between 10 a.m. and 4 p.m. of that day;
    - a ratio of consumption over one day to maximum level of sunlight between 12 p.m. and 2 p.m. of that day;
    - a ratio between the average daily consumption for the X days with higher levels of sunlight and the average consumption for the X days with lower levels of sunlight;
    - an average ratio of consumption per day per degrees of temperature;
    - an average ratio between consumption per day per degree of temperature for the X days with higher levels of sunlight and consumption per day per degree of temperature for the X days with lower levels of sunlight.

11. Computer program comprising instructions for implementing the method according to one of claims 1 to 10, when said instructions are executed by a processor of a processing module (MOD).

12. Processing module (MOD) configured to implement the following steps:

- obtaining first data from consumption records from each meter by regular time intervals,
- obtaining second data (MET) which are meteorological data in the geographical area, in order to identify at least some weather conditions conducive to the production of energy by said autonomous means,
- for each meter, applying a model for detecting, based on at least the first and second data, a coincidence between periods of low consumption measured by the meter and weather conditions conducive to electricity production by said autonomous means during said periods, and deducing, from the application of the model, information on the presence of autonomous means in the dwelling equipped with this meter,

the module comprising an output (OUT) for feeding the database stored in the memory (MEM) of a server (SER).

13. Server comprising a processing module (MOD) according to claim 12 and said memory (MEM).

[Fig. 1]

[Fig. 2]

FIG. 1

[Fig. 3]

FIG. 2

EP 3 648 020 B1

[Fig. 4]

Température

Irradiance 12h 16h

Irradiance jour

Consommation jour

1*7*4

n Convolutions 1*1*4

1*7*n

Max Pooling 1*7*n

1*1*n

=

n neurones

m neurones

Couche Softmax avec deux sorties

FIG. 3

FIG. 4